Europäisches Patentamt

European Patent Office

Office européen des brevets

(19)

(11) Numéro de publication: **0 125 954**
**A1**

(12) **DEMANDE DE BREVET EUROPEEN**

(21) Numéro de dépôt: **84400736.9**

(22) Date de dépôt: **12.04.84**

(51) Int. Cl.³: **C 03 C 17/245**
**C 23 C 11/08, C 04 B 41/06**

(30) Priorité: **12.04.83 JP 64101/83**

(43) Date de publication de la demande:
**21.11.84 Bulletin 84/47**

(84) Etats contractants désignés:
**AT BE CH DE FR GB IT LI LU NL SE**

(71) Demandeur: **SAINT-GOBAIN VITRAGE**
**Les Miroirs 18, avenue d'Alsace**
**F-92400 Courbevoie(FR)**

(72) Inventeur: **Kato, Yukihiro**
**2-1-403 Nigawa-cho 2-chome**
**Nishinomiya-shi Hyogo-ken(JP)**

(72) Inventeur: **Kawahara, Hidéo**
**8-3-205 Minami Sakurazuka 2-chome**
**Toyonaka-shi Osaka-fu(JP)**

(72) Inventeur: **Hyodo, Masato**
**21 Nakano Hagashi 3-chome**
**Itami-shi Hyogo-ken(JP)**

(74) Mandataire: **Leconte, Jean-Gérard et al,**
**Saint-Gobain Recherche 39, Quai Lucien Lefranc**
**F-93304 Aubervilliers Cedex(FR)**

(54) **Couche d'oxyde d'étain à caractéristiques électriques améliorées obtenues à partir de composés gazeux.**

(57) Dépôt d'une couche d'oxyde d'étain à partir de tétraméthyl étain et/ou de tétraéthyl étain gazeux dopé (o) avec un fluorure répondant à la formule $XCHF_2$ où X est un groupement à base de carbone et d'hydrogène, du chlore ou du fluor.

Obtention de revêtements aux propriétés électriques améliorées.

EP 0 125 954 A1

0125954

COUCHE D'OXYDE D'ETAIN A CARACTERISTIQUES ELECTRIQUES AMELIOREES

OBTENUE A PARTIR DE COMPOSES GAZEUX

La présente invention concerne le dépôt d'une couche d'oxyde d'étain sur la surface d'un substrat en verre, céramique, métal ou autre matières.

Plus précisément, elle porte sur une méthode de dépôt d'une couche d'oxyde d'étain par la mise en contact de composés organiques d'étain à l'état gazeux avec la surface d'un substrat en verre, céramique, métal ou autres matières, chauffé à une haute température. En général, la couche d'oxyde d'étain étant très dure, elle est utilisée largement pour éviter la détérioration de la surface des vaisselles, bouteilles, etc. Par ailleurs, il y a de nombreuses applications profitant de la conduction électrique de la couche d'oxyde d'étain ; par exemple, les verres revêtus d'une telle couche sont largement employés comme conducteurs transparents tels qu'électrodes pour des cristaux liquides, verres anti-buée, etc. Egalement, des plaquettes céramiques fines revêtues d'une couche d'oxyde d'étain sont extrêmement employées en tant que pièces électriques. En plus, en profitant du caractère réflecteur des rayons infra-rouges de la couche d'oxyde d'étain, des verres ou tubes métalliques revêtus d'une couche d'oxyde d'étain sont utilisés comme couvercles ou tubes de capteurs solaires.

Il existe plusieurs méthodes pour déposer une couche d'oxyde d'étain sur la surface d'un substrat en verre, céramique, métal ou autres matières. Comme méthode appropriée pour la fabrication en série, on utilise depuis longtemps la méthode qui consiste à pulvériser une solution de tétrachlorure d'étain sur la surface du substrat maintenu à haute température. Depuis quelques années, on utilise également la méthode dite "CVD" (Coating Vapor deposition), qui consiste à mettre en contact la vapeur obtenue par chauffage et vaporisation de tétrachlorure d'étain ou de diméthyl dichlorure d'étain, avec un substrat en verre, céramique, métal ou autres matières chauffé à haute température.

Toutefois, les couches d'oxyde d'étain ainsi obtenues présentent par endroit des zones troubles d'aspect légèrement laiteux. Ce défaut est d'autant plus marqué que la couche d'oxyde d'étain est plus épaisse. Ces couches ayant ces défauts ne peuvent pas être utilisées pour constituer des électrodes de verre pour afficheurs de grandes tailles, les couches dans ce cas devant être parfaitement transparentes ainsi qu'uniformes et homogènes, devant également posséder de bonnes performances électriques et de faibles résistances électriques.

Pour atténuer ces défauts, on a essayé de déposer une vapeur constituée par un mélange de tétraméthyl étain $(CH_3)_4Sn$ et de bromotrifluoro-méthane $(CF_3Br)$ sur des substrats en verre préalablement revêtus d'une sous couche d'oxyde de silicium. En l'absence de cette sous couche, le revêtement est pratiquement inexistant, et en plus le tétraméthyl étain est très toxique, ce qui rend son emploi non approprié au CVD.

On a par ailleurs proposé d'employer le dibutyl-diacétate d'étain $(C_4H_9)_2Sn(CH_3COO)_2$ moins toxique que le tétraméthyl étain, en mélange avec du bromotrifluorométhane $(CF_3Br)$, mais le dépôt obtenu n'a pas une bonne résistance mécanique, ni une bonne conduction électrique.

La présente invention vise à fabriquer des couches de revêtement de substrats par la méthode C.V.D. à partir de composés moins toxiques que le tétraméthyl étain, ces couches ayant une grande homogénéité, de bonnes propriétés électriques en particulier une faible résistance électrique, et ne faisant pas apparaître de trouble.

Pour cela elle propose d'employer comme composé organique l'un au moins des composés que sont le tétraméthyl étain et le tétraéthyl étain, un fluorure du type $XCHF_2$ où X est un radical hydrocarboné à base de carbone et d'hydrogène, du chlore ou du fluor, étant préalablement ajouté au composé pour agir en tant que dopant.

Pour obtenir des caractéristiques optimales du revêtement, il est souhaitable que la vitesse de projection de la vapeur sur le substrat à revêtir soit inférieure à 15 m/s et de préférence comprise entre 0,2 et 8 m/s.

En outre on ajuste la quantité de fluorure $XCHF_2$ ajouté par rapport à celle de tétraméthyl étain et/ou de tétraéthyl étain, de façon qu'il y ait en poids, une proportion de fluor par rapport à l'oxyde d'étain du revêtement obtenu qui soit comprise entre 0,3 et 1,5 % et de préférence entre 0,9 et 1,2 %.

Comme fluorure, on emploie le 1,1-difluoruéthane, le trifluorométhane ou le chlorodifluoroéthane avec une préférence pour le 1,1 difluoroéthane.

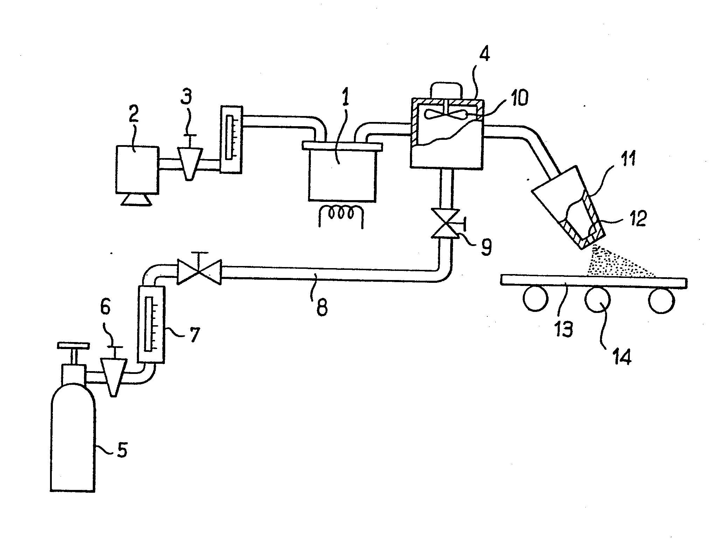

L'invention sera maintenant décrite plus en détail en référence à la figure jointe qui représente un schéma du dispositif permettant de vaporiser le composé d'étain et de le mettre en contact avec le substrat chauffé.

De la vapeur d'un composé d'étain est produite dans un vaporisateur 1. Ce vaporisateur est traversé par un courant de gaz vecteur fourni par un compresseur 2 associé à un détendeur 3. Ce gaz vecteur entraîne la vapeur de composé d'étain lors de sa traversée du vaporisateur 1, jusqu'à un mélangeur 4. Ce même mélangeur 4 reçoit par ailleurs un autre composé gazeux destiné à doper le composé d'étain. Ce dopant emmagasiné dans une bouteille 5 est détendu par un détendeur 6, dosé par un débitmètre 7 puis acheminé par un tuyau 8 muni d'une vanne 9 jusqu'au mélangeur 4. Dans ce mélangeur 4, la vapeur de composé d'étain et le dopant gazeux sont intimement mélangés grâce à un agitateur 10. A la sortie du mélangeur 4, le mélange ainsi réalisé est acheminé jusqu'à une buse de projection 11 munie d'une fente de distribution 12 pour être projeté sur un substrat 13 par exemple en verre, notamment les feuilles de verre ou un ruban continu de verre, entraîné en défilement sous la buse 11 grâce à des rouleaux 14.

Comme composé d'étain on emploie le tétraméthyl étain $(CH_3)_4Sn$ ou le tétraéthyl étain $(C_2H_5)_4Sn$.

Pour ce qui concerne le tétraméthyl étain, on le laisse se vaporiser seul dans une bouteille non représentée sur la figure et en communication avec le vaporisateur 1.

Pour ce qui concerne le tétraéthyl étain, on le chauffe à une température comprise entre 40 et 90°C dans le vaporisateur pour obtenir la vapeur de composé d'étain et on le dirige vers le mélangeur 4 à l'aide d'un gaz porteur, en particulier l'azote.

Le mélange gazeux obtenu avec l'un des dopants et un composé d'étain a été projeté sur des substrats en verre sodocalcique de 50 mm X 300 mm et de 3 mm d'épaisseur, soit nus (exemples 3 et 4), soit revêtus d'une sous-couche de silice $SiO_2$ de 1000 Angstroëms d'épaisseur (exemples 1 et 2) ces substrats étant dans les deux cas chauffés à 540°C et entraînés à une vitesse par rapport à la buse 11 de 30 cm/min.

Le fente 12 de distribution était disposée à 10 mm environ de distance du substrat en verre 13 défilant sous elle, le gaz porteur était délivré avec une pression de 1 kg/min et avec un débit de 5 l/min.

On a réalisé sur différents échantillons de substrats 13 des revêtements de 2000 Angstroëms d'épaisseur en employant chacun des deux composés d'étain de l'invention successivement avec chacun des dopants répondant à la formule $XCHF_2$, que sont le 1,1 difluoroéthane, et le trifluorométhane (exemples 1, 2, 3 et 4).

On a choisi pour chaque dopant des proportions telles que la valeur de la résistance électrique des couches d'oxyde d'étain obtenues soit la plus faible possible.

Pour obtenir des comparaisons, en utilisant d'abord les mêmes composés d'étain, à savoir le tétraméthyl étain et le tétraéthyl étain, puis un autre composé d'étain, le dibutyl diacétate d'étain, on a changé de dopant et employé le bromotrifluorométhane ($CF_3Br$), pour réaliser des revêtements sur des verres portant une sous couche de silice (exemples 5, 6, 7).

Toujours à titre de comparaison, avec le tétraméthyl étain comme composé d'étain, et successivement avec le dichlorodifluorométhane ($CCl_2F_2$) et le chlorotrifluorométhane ($CClF_3$) comme dopant, on a réalisé d'autres revêtements (exemples 8 et 9).

Dans chaque cas on a mesuré la résistance électrique des couches obtenues, ou plus précisément la résistivité exprimée en ohm.cm.

Les résultats ont été reportés dans le tableau disposé en fin de description. Les quantités de composés d'étain en grammes/heure et de dopant en litres/heure sont à chaque fois exprimées par un chiffre dans la case correspondante.

On constate que quelle que soit la matière du substrat, verre nu ou verre revêtu de silice, les couches sont de bonne qualité et présentent de bonnes caractéristiques électriques.

On constate également que les revêtements obtenus selon l'invention, à savoir ceux des exemples 1, 2, 3 et 4 ont des propriétés électriques meilleures que les revêtements hors invention, à savoir ceux des exemples 5, 6, 7, 8 et 9.

Les revêtements avec d'autres dopants répondant à la formule

$XCHF_2$, tels que le chlorodifluoroéthane, ont également donné de bons résultats.

L'association des deux composés d'étain que sont le tétraméthyl et le tétraéthyl étain est également possible.

## TABLEAU

===========

| | ref | matières premières de départ et doses | | résistivité électrique (ohms.cm) |
|---|---|---|---|---|
| | | composés d'étain (grammes/heure) | dopants (litres/heure) | |
| **INVENTION** | 1 | Tétraméthyl étain 7 | 1,1-difluoroéthane 48 | $6.4 \times 10^{-4}$ |
| | 2 | Tétraméthyl étain 7 | trifluorométhane 78 | $8.5 \times 10^{-4}$ |
| | 3 | Tétraéthyl étain 8 | 1.1-difluoroéthane 78 | $7.7 \times 10^{-4}$ |
| | 4 | Tétraéthyl étain 8 | Trifluorométhane 78 | $9.0 \times 10^{-4}$ |
| **EXEMPLES COMPARATIFS** | 5 | Tétraméthyl étain 7 | Bromotrifluorométhane 60 | $1.1 \times 10^{-3}$ |
| | 6 | Tétraéthyl étain 8 | Bromotrifluorométhane 60 | $1.9 \times 10^{-3}$ |
| | 7 | Dibutyl diacétate d'étain 4 | Bromotrifluorométhane 60 | $2.7 \times 10^{-3}$ |
| | 8 | Tetraméthyl étain 7 | Dichlorodifluoro méthane 54 | $5.6 \times 10^{-3}$ |
| | 9 | Tetraméthyl étain 7 | Chlorotrifluorométhane 60 | $1.0 \times 10^{-3}$ |

REVENDICATIONS

0125954

1. Procédé de dépôt d'une couche d'oxyde d'étain sur un substrat, notamment en verre, consistant à mettre une vapeur contenant des composés d'étain en contact avec le substrat porté à haute température caractérisé en ce que la vapeur contient un dopant répondant à la formule générale $XCHF_2$ où X est un groupement à base de carbone et d'hydrogène, du chlore ou du fluor et des composés d'étain constitués par au moins l'un des composés que sont le tétraméthyl étain et le tétraéthyl étain.

2. Procédé selon la revendication 1, caractérisé en ce que le dopant appartient au groupe des produits suivants : chlorodifluorométhane, trifluorométhane, 1.1 difluoroéthane.

3. Procédé selon l'une des revendications précédentes caractérisé en ce que la vapeur est projetée sur le substrat avec une vitesse inférieure à 15 m/s et de préférence comprise entre 0,2 et 8 m/s.

4. Procédé selon l'une des revendications précédentes caractérisé en ce que la proportion de fluorure $XCHF_2$ est telle qu'il y ait en poids dans la couche obtenue une proportion de fluor par rapport à l'oxyde d'étain qui soit comprise entre 0,3 et 1,5 % et de préférence entre 0,9 et 1,2 %.

0125954

Office européen
des brevets

**RAPPORT DE RECHERCHE EUROPEENNE**

Numéro de la demande

EP 84 40 0736

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. 3) |
|---|---|---|---|
| X | EP-A-0 027 403 (SAINT-GOBAIN VITRAGE) <br> * revendication 1; page 2, lignes 5-19; page 3, lignes 2-6 * | 1,2 | C 03 C 17/245 <br> C 23 C 11/08 <br> C 04 B 41/06 |
| | --- | | |
| A | FR-A-2 439 240 (R.G. GORDON) <br> * revendications 18,19; page 1, lignes 1-15; page 4, lignes 16-19; page 5, lignes 13-40; page 7, lignes 27-40; page 9, lignes 16-31 * | 1,4 | |
| | ----- | | |

DOMAINES TECHNIQUES RECHERCHES (Int. Cl. 3)

C 03 C 17/245
C 23 C 11/08

Le présent rapport de recherche a été établi pour toutes les revendications

| Lieu de la recherche | Date d'achèvement de la recherche | | Examinateur |
|---|---|---|---|
| LA HAYE | 23-07-1984 | GAJ A. | |